**Europäisches Patentamt**

**European Patent Office**

**Office européen des brevets**

(19)

(11) Veröffentlichungsnummer: **0 055 358**
**B1**

(12) ## EUROPÄISCHE PATENTSCHRIFT

(45) Veröffentlichungstag der Patentschrift:
**27.06.84**

(21) Anmeldenummer: **81108845.9**

(22) Anmeldetag: **24.10.81**

(51) Int. Cl.³: **C 08 G 73/06, H 01 B 1/12**

(54) Elektrisch leitfähige Poly(pyrrol)-Derivate.

(30) Priorität: **31.12.80 DE 3049551**

(43) Veröffentlichungstag der Anmeldung:
**07.07.82 Patentblatt 82/27**

(45) Bekanntmachung des Hinweises auf die Patenterteilung:
**27.06.84 Patentblatt 84/26**

(84) Benannte Vertragsstaaten:
**BE CH DE FR GB IT LI LU NL SE**

(56) Entgegenhaltungen:
**IBM TECHNICAL DISCLOSURE BULLETIN, Band 22, Nr. 4, September 1979 NEW YORK (USA) A.F. DIAZ u.a. "Polypyrrole Copolymer", Seiten 1638 und 1639**

(73) Patentinhaber: **BASF Aktiengesellschaft,
Carl-Bosch-Strasse 38, D-6700 Ludwigshafen (DE)**

(72) Erfinder: **Naarmann, Herbert, Dr., Haardtblick 15,
D-6719 Wattenheim (DE)**
Erfinder: **Naegele, Dieter, Dr., Obere Jakobstrasse 8,
D-6520 Worms (DE)**
Erfinder: **Penzien, Klaus, Dr., Bensheimer Ring 18,
D-6710 Frankenthal (DE)**
Erfinder: **Schlag, Johannes, Dr., Leuschnerstrasse 36,
D-6700 Ludwigshafen (DE)**
Erfinder: **Kiener, Volker, Dr., Kalmitstrasse 20,
D-6714 Weisenheim (DE)**
Erfinder: **Boehn, Hugo, Muehlaustrasse 11,
D-6700 Ludwigshafen (DE)**

**Beschreibung**

Die Erfindung betrifft elektrisch leitfähige Polypyrrole sowie ihre Herstellung durch elektrochemische Polymerisation von Pyrrolen in Gegenwart nitrogruppenhaltiger Leitsalze, wobei filmförmige Materialien mit hoher elektrischer Leitfähigkeit und gleichzeitig hohem mechanischem Niveau erhalten werden.

Aus D. E. Weiss et.al., Austr. J. Chem. 16, Seiten 1056, 1076 und 1096 (1963) ist die Pyrolyse von Tetrajodpyrrol bekannt. Hierbei entstehen elektrisch leitfähige Pulver mit Leitfähigkeiten bis $10^{-1}$ $[\Omega^{-1} cm^{-1}]$. Die hohe Leitfähigkeit ist auf eine Komplexbildung zwischen dem unlöslichen Poly(pyrrol) und Jod zurückzuführen.

Die US-Patentschrift 3 574 072 beschreibt die elektrochemische Polymerisation von 5-Ring-Heterocyclen, u. a. von Pyrrol; über die elektrische Leitfähigkeit und die Verarbeitbarkeit der erhaltenen pulverförmigen Materialien werden jedoch keine Angaben gemacht.

Aus Arbeiten von A. F. Diaz et.al., J.C.S. Chem. Comm. 1979, 634, J.C.S. Chem. Comm, 1979, 854, ACS Org. Coat. Plast. Chem. 43, (1980) wurde bekannt, daß durch anodische Polymerisation von Pyrrol in Gegenwart von Leitsalzen Filme mit elektrischen Leitfähigkeiten bis zu $10^2$ $[\Omega^{-1} cm^{-1}]$ gebildet werden. Hierbei handelt es sich um p-leitende Poly(pyrrole), wobei als Gegenionen vor allem $BF_4^{\ominus}$, $AsF_6^{\ominus}$, $ClO_4^{\ominus}$ und $HSO_4^{\ominus}$ genannt werden. Mechanische Daten dieser Filme sind jedoch nicht angegeben.

Der Erfindung lag die Aufgabe zugrunde, elektrisch hochleitfähige Polymere mit gleichzeitig hohem mechanischem Niveau zu entwickeln.

Diese Aufgabe wird durch die Bereitstellung von Poly(pyrrol)-Komplexen mit Nitroaromat-Anionen gelöst.

Die Komplexe bestehen aus einem Poly(pyrrol)-Kation und Nitroaromat-Anionen. Sie werden erfindungsgemäß hergestellt durch anodische Oxidation eines Pyrrols in einem polaren Lösungsmittel in Gegenwart von Salzen saurer Nitroaromaten.

Als Monomere finden Pyrrol, N-Alkylpyrrole und N-Arylpyrrole Einsatz. Innerhalb der Serie der N-Arylpyrrole sind N-Phenylpyrrol und kernsubstituierte N-Phenylpyrrole mit nicht reaktiven Substituenten 2. Ordnung, z. B. Nitrophenylpyrrole, bevorzugt. Die Monomerkonzentration beträgt im allgemeinen 0,1 Mole pro Liter Lösungsmittel. Da die Elektrolyse meist nur bis zu kleinen Umsätzen durchgeführt wird, kann diese Konzentration in weiten Grenzen unterschritten, aber auch überschritten werden.

Die erfindungsgemäßen Leitsalze sind Nitroaromaten mit sauren Gruppen. Hierzu zählen Nitrophenole, Nitrogruppen — substituierte aromatische Carbonsäuren und Nitrogruppen — substituierte aromatische Sulfonsäuren. Insbesondere finden Nitro-, Dinitro-, Trinitrophenole, Nitro-, Dinitro-, Trinitrobenzoesäuren und Nitro-, Dinitro-, Trinitrobenzolsulfonsäuren Einsatz. Auch Nitroaromaten mit mehreren sauren Gruppen, wie phenolischen Hydroxylgruppen, Carboxylgruppen und Sulfonsäuregruppen sind geeignet. Auch die als Farbstoff-Vorprodukte bekannten, kondensierten Nitroaromaten mit sauren Gruppen können eingesetzt werden. Ferner sind saure Aromaten mit Nitrosogruppen geeignet. Die Leitsalzkonzentration beträgt 0,001 bis 1, vorzugsweise 0,01 bis 0,1 Mole pro Liter.

Bei der Herstellung der erfindungsgemäßen Poly(pyrrol)-Komplexe wird bevorzugt mit einer einfachen Elektrolysenanordnung, bestehend aus einer Zelle ohne Diaphragma und zwei Edelmetallelektroden, bevorzugt Platinelektroden, gearbeitet. Zumindest die Anode, auf der sich während der Elektrolyse die Filme abscheiden, muß flächig ausgebildet sein. Auch andere Elektrolyseeinrichtungen, beispielsweise Zellen mit Diaphragma oder solche mit Referenzelektroden zur exakten Potentialbestimmung, können Einsatz finden. Zur Kontrolle der Schichtstärke der abgeschiedenen Filme ist eine Messung der Strommenge (Amp · sec) zweckmäßig.

Die Elektrolyse wird bevorzugt in polaren organischen Lösungsmitteln, die Pyrrol und Leitsalz lösen, durchgeführt. Wasser kann zur Erhöhung der elektrischen Leitfähigkeit zugesetzt werden, wenn mit Wasser mischbare organische Lösungsmittel Einsatz finden. Bevorzugte Lösungsmittel sind Alkohole, Äther wie Dioxan oder 1,2-Dimethoxiäthan, Eisessig, Aceton, Dimethylformamid oder N-Methylpyrrolidon.

Normalerweise führt man die Elektrolyse bei Raumtemperatur und unter Inertgas durch. Die Reaktionstemperatur hat sich bei den Versuchen mit Pyrrol als Monomer als unkritisch erwiesen, solange Erstarrungstemperatur bzw. Siedetemperatur des Elektrolyten nicht unter- bzw. überschritten werden.

Die während der Elektrolyse von Pyrrolderivaten in Gegenwart von Nitrogruppen-haltigen Leitsalzen anodisch abgeschiedenen Filme werden zur Entfernung von anhaftendem Leitsalz mit Lösungsmittel gewaschen und bei Temperaturen von 50 bis 150° C getrocknet. Danach lassen sie sich leicht von der Elektrode ablösen, vor allem wenn Schichtstärken über 50 µm abgeschieden wurden.

Zur Messung von Reißkraft und Reißfestigkeit werden Filme mit definierter Abmessung (Einspannlänge 25 mm, Meßlänge 10 mm, Breite 4 mm) gemäß DIN 53 504 auf einer INSTRON 1112-Maschine bis zum Bruch gestreckt. Die Filme erfahren hierbei nur eine unwesentliche Dehnung.

Die elektrische Leitfähigkeit in $[\Omega^{-1} cm^{-1}]$ wird durch Kontaktierung der Filme mit Leitsilber und Messung nach der Zweipunktmethode bestimmt. Identische Ergebnisse erhält man durch Messung nach der Vierpunktmethode, wobei die Übergangswiderstände der Kontaktierung keine Rolle spielen können. Ein Beitrag von Ionenleitung zum Stromfluß konnte nicht festgestellt werden.

Die erfindungsgemäßen Poly(pyrrol)-Komplexe mit hoher elektrischer Leitfähigkeit und hohem mechanischem Niveau können zur Herstellung von Elektroden, Katalysatoren, Batterien, Schaltern, Halbleiter-Bauteilen, Solarzellen und zur antistatischen Ausrüstung von Kunststoffen Einsatz finden. Vor allem führen sie dort zu einem technischen Fortschritt, wo ein hohes mechanisches Niveau der Bauteile von Bedeutung ist.

### Beispiel 1

In einem Glasgefäß werden 120 ml Acetonitril, 0,48 g Pyrrol und 0,39 g des Tributylammoniumsalzes von m-Nitrobenzolsulfonsäure vorgelegt. Man bringt zwei Platin-Elektroden von je 14 cm$^2$ Fläche im Abstand von 4 cm in die Lösung und läßt unter Rühren eine Strommenge von 140 Amp · sec fließen. Hierbei scheidet sich ein schwarzer Film auf der Anode ab. Nach Spülen der beschichteten Anode mit Acetonnitril und Trocknung bei 60° C läßt sich der Film vom Platin ablösen.

Eigenschaften des Films:

| | |
|---|---|
| Reißfestigkeit: | 51 N/mm$^2$ |
| elektrische Leitfähigkeit: | 80 $\Omega^{-1} \cdot cm^{-1}$ |
| Schichtstärke: | 78 μm |
| Schwefelgehalt: | 8,6% |

### Beispiel 2

Es wird gemäß Beispiel 1 gearbeitet, jedoch findet als Leitsalz das Tributylammoniumsalz der 2,6-Dinitrophenol-4-sulfonsäure Einsatz.

Eigenschaften des Films:

| | |
|---|---|
| Reißfestigkeit: | 60 N/mm$^2$ |
| elektrische Leitfähigkeit: | 43 $\Omega^{-1} \cdot cm^{-1}$ |
| Schichtstärke: | 58 μm |
| Schwefelgehalt: | 7,8% |

### Beispiel 3

In einem Glasgefäß werden 120 ml Acetonitril, 0,48 g Pyrrol, 1,4 g 2-Nitrophenol und 1,85 g Tributylamin gerührt. Bei Arbeitsweise gemäß Beispiel 1 erhält man einen Film mit folgenden Eigenschaften:

| | |
|---|---|
| Reißfestigkeit: | 41 N/mm$^2$ |
| elektrische Leitfähigkeit: | 21 $\Omega^{-1} \cdot cm^{-1}$ |
| Schichtstärke: | 62 μm |
| Sauerstoffgehalt: | 12% |

### Beispiel 4

In einem Glasgefäß werden 120 ml Acetonitril, 0,48 g Pyrrol, 1,23 g 2-Hydroxi-3,5-dinitro-benzoesäure und 0,93 g Tributylamin gerührt. Bei Arbeitsweise gemäß Beispiel 1 erhält man einen Film mit folgenden Eigenschaften:

| | |
|---|---|
| Reißfestigkeit: | 35 N/mm$^2$ |
| elektrische Leitfähigkeit: | 33 $\Omega^{-1} \cdot cm^{-1}$ |
| Schichtstärke: | 57 μm |
| Sauerstoffgehalt: | 22% |

### Beispiel 5

In einem Glasgefäß werden unter Argon 120 ml Acetonitril, 0,56 g N-Methylpyrrol und 0,39 g des Tributylammoniumsalzes von m-Nitrobenzolsulfonsäure gerührt. Nach Arbeitsweise gemäß Beispiel 1, jedoch mit einer Strommenge von 80 Amp · sec, erhält man einen Film mit folgenden Eigenschten:

| | |
|---|---|
| Reißfestigkeit: | 19 N/mm$^2$ |
| elektrische Leitfähigkeit: | 16 $\Omega^{-1} \cdot cm^{-1}$ |
| Schichtstärke: | 61 μm |
| Schwefelgehalt: | 6,3% |

### Beispiel 6

In einem Glasgefäß werden unter Argon 120 ml Acetonitril, 0,61 g N-(2-Nitrophenyl)-pyrrol und 0,45 g des Tributylammoniumsalzes von m-Nitrobenzolsulfonsäure gerührt. Nach Arbeitsweise gemäß Beispiel 1 erhält man einen Film mit folgenden Eigenschaften:

| | |
|---|---|
| Reißfestigkeit: | 20 N/mm$^2$ |
| elektrische Leitfähigkeit: | 14 $\Omega^{-1} \cdot cm^{-1}$ |
| Schichtstärke: | 65 μm |
| Schwefelgehalt: | 5,4% |

### Vergleichsversuche

A. In einem Glasgefäß werden 120 ml Acetonitril, 0,84 ml Wasser, 0,48 g Pyrrol und 0,8 g Tetramethylammoniumtetrafluorborat gerührt. Nach Durchfluß einer Strommenge von 100 Amp · sec und ansonsten Arbeitsweise gemäß Beispiel 1 erhält man einen Film mit folgenden Eigenschaften:

| | |
|---|---|
| Reißfestigkeit: | 3,0 N/mm$^2$ |
| elektrische Leitfähigkeit: | 15 $\Omega^{-1} \cdot cm^{-1}$ |
| Schichtstärke: | 55 μm |
| Fluorgehalt: | 21,7% |

B. In einem Glasgefäß werden 120 ml Acetonitril, 0,84 ml Wasser, 0,48 g Pyrrol und 1,18 g konzentrierte Schwefelsäure gerührt. Nach Durchfluß einer Strommenge von 100 Amp · sec und ansonsten Arbeitsweise gemäß Beispiel 1 erhält man einen Film mit folgenden Eigenschaften:

| | |
|---|---|
| Reißfestigkeit: | 15 N/mm$^2$ |
| elektrische Leitfähigkeit: | 7 $\Omega^{-1} \cdot cm^{-1}$ |
| Schichtstärke: | 20 μm |
| Schwefelgehalt: | 9,3% |

C. In einem Glasgefäß werden 120 ml Acetonitril, 0,84 ml Wasser, 0,48 g Pyrrol und 1,15 g K(AsF$_6$) gerührt. Nach Durchfluß einer Strommenge von 100 Amp · sec und ansonsten Arbeitsweise gemäß Beispiel 1 erhält man einen Film mit folgenden Eigenschaften:

| | |
|---|---|
| Reißfestigkeit: | 18 N/mm² |
| elektrische Leitfähigkeit: | 50 $\Omega^{-1} \cdot cm^{-1}$ |
| Schichtstärke: | 32 µm |
| Fluorgehalt: | 25,3%. |

**Patentansprüche**

1. Elektrisch leitfähige Komplexe von Poly(pyrrolen) mit Nitroaromat-Anionen.

2. Elektrisch leitfähige Kompexe nach Anspruch 1, dadurch gekennzeichnet, daß sie auf Basis von Pyrrol, einem N-Alkylpyrrol und/oder einem N-Arylpyrrol aufgebaut sind.

3. Elektrisch leitfähige Komplexe nach Anspruch 1, dadurch gekennzeichnet, daß sie auf Basis von Nitrophenol, Nitro-substituierten aromatischen Carbonsäuren und/oder Nitro-substituierten aromatischen Sulfonsäuren aufgebaut sind.

4. Verfahren zur Herstellung der elektrisch leitfähigen Komplexe nach Anspruch 1 bis 3, dadurch gekennzeichnet, daß ein Pyrrol durch anionische Oxidation in einem polaren Lösungsmittel in Gegenwart von Salzen saurer Nitroaromaten polymerisiert wird.

5. Filme aus den elektrisch leitfähigen Komplexen nach Anspruch 1.

**Claims**

1. An electrically conductive complex of a polypyrrole with a nitroaromatic anion.

2. An electrically conductive complex as claimed in claim 1, whose polypyrrole component is based on pyrrole, an N-alkylpyrrole and/or an N-arylpyrrole.

3. An electrically conductive complex as claimed in claim 1, whose nitroaromatic anion component is based on nitrophenol, a nitroaromatic carboxylic acid and/or a nitroaromatic sulfonic acid.

4. A process for the preparation of an electrically conductive complex as claimed in claims 1 to 3, wherein a pyrrole is polymerized by anionic oxidation in a polar solvent, in the presence of a salt of an acidic nitroaromatic compound.

5. A film produced from an electrically conductive complex as claimed in claim 1.

**Revendications**

1. Complexes conducteurs de l'électricité de polypyrroles avec des anions de composés aromatiques nitrés.

2. Complexes conducteurs de l'électricité selon la revendication 1, caractérisé en ce qu'ils sont réalisés à partir de pyrrole, d'un N-alcoylpyrrole (et (ou) d'un N-aryl-pyrrole.

3. Complexes conducteurs de l'électricité selon la revendication 1, caractérisés en ce qu'ils sont réalisés à partir du nitro-phénol, d'acides carboxyliques aromatiques nitro-substitués et (ou) d'acides sulfoniques aromatiques nitro-substitués.

4. Procédé de préparation de complexes conducteurs de l'électricité selon les revendications 1 à 3, caractérisé en ce que l'on polymérise un pyrrole dans un solvant polaire par une oxydation anionique en présence de sels de composés aromatiques nitrés acides.

5. Pellicules en complexes conducteurs de l'électricité selon la revendication 1.